# EUROPÄISCHE PATENTSCHRIFT

(11) **EP 0 560 787 B1**
(45) Veröffentlichungstag und Bekanntmachung des Hinweises auf die Patenterteilung: **21.08.1996**
(21) Anmeldenummer: 91919084.3
(22) Anmeldetag: 11.11.1991
(51) Int. Cl.: H01L 21/301, H01L 21/822, H01L 23/544

(54) **Verfahren zur Kennzeichnung gemeinsam auf einer Platte hergestellte und danach vereinzelte Halbleiter-Chips.**
Method of marking semiconductor chips manufactured together on a wafer and then separated.
Procédé de marquer des puces semiconductrices fabriquées ensemble sur une plaquette et puis separées

(30) Priorität: 05.12.1990 DE 4038723
(43) Veröffentlichungstag der Anmeldung: 22.09.1993
(73) Patentinhaber: ROBERT BOSCH GMBH, 70442 Stuttgart (DE)
(72) Erfinder: THIENEL, Christoph, D-7410 Reutlingen 23 (DE)
(86) Internationale Anmeldenummer: DE9100871
(87) Internationale Veröffentlichungsnummer: WO9210852

(56) Entgegenhaltungen:
- US-A- 3 562 536
- US-A- 4 134 066
- PATENT ABSTRACTS OF JAPAN vol. 10, no. 359 (E-460)(2416) 3. Dezember 1986 & JP, A,61 156 839 ( MITSUBISHI ELECTRIC CORP. ) 16. Juli 1986 siehe Zusammenfassung
- IBM TECHNICAL DISCLOSURE BULLETIN. Bd. 14, Nr. 4, September 1971, NEW YORK US Seiten 1030 - 1031; R.C. FAHRNI ET AL.: 'Wafer identification' siehe das ganze Dokument
- PATENT ABSTRACTS OF JAPAN vol. 7, no. 239 (E-206)(1384) 25. Oktober 1983 & JP, A,58 128 722 ( NIPPON DENKI K.K. ) 1. August 1983 siehe Zusammenfassung

## Beschreibung

### Stand der Technik

Die Erfindung betrifft auf einer Platte gemeinsam hergestellte und danach vereinzelte, gleichartige Halbleiter-Chips. In bekannter Weise werden heutzutage Halbleiterbauelemente bzw. -Chips rationell auf als Wafer bezeichneten scheibenförmigen Platten hergestellt, die von stabförmigen Silicium-Einkristallen abgesägt werden. Durch verschiedene Technologien, wie Fotolithografie, Epitaxie, Diffusion, Maskierungstechnik und dgl. entstehen dann auf einer solchen Platte eine Vielzahl gleichartiger integrierter Schaltkreise, die nach Vereinzelung in einzelne Chip-Kristalle voneinander nicht mehr unterschieden werden können. Treten später gehäuft Defekte in den Schaltkreisen auf, so kann nachträglich nicht mehr festgestellt werden, ob es sich dabei um statistisch verteilte oder um in bestimmten Regionen der Platten gehäufte Defekte handelt. Für die Suche nach der Ursache der Defekte wäre es von großem Vorteil, wenn nachträglich noch die ursprüngliche Position des jeweiligen Chips auf der Platte festgestellt werden könnte.

Aus PATENT ABSTRACTS OF JAPAN 7(239),(E-206)[1384] ist es bereits bekannt, jeden Halbleiterchip auf einer Platte mit einer Kennzeichnung zu versehen, die ihre Position auf der Platte beinhaltet.

PATENT ABSTRACTS OF JAPAN 10(359),(E-460)[2416] beschreibt die Markierung von Chip-Gehäusen, wobei die frühere Position des Chips auf einer Platte angegeben ist.

Aus US-A-3 562 536 ist es bekannt, eine Halbleiterplatte mit Information auf den zwischen den Chips liegenden Randbereichen zu versehen. Die Information dient zur Identifizierung der Platte und wird bei der Vereinzelung der Chips zerstört.

### Vorteile der Erfindung

Die erfindungsgemäße Lösung mit den kennzeichnenden Merkmalen des Hauptanspruchs hat den Vorteil, daß von den einzelnen Chips auch noch nach der Vereinzelung die frühere Position auf der Platte abgelesen werden kann. Die Einzelschicksale der Chips können dann mit deren früherer Lage auf der Platte korreliert werden. Da diese Kennzeichnungen während des Herstellungsprozesses zusammen mit den Halbleiterstrukturen der Chips angebracht werden können, erhöht sich der Herstellungsaufwand nur unwesentlich. Beispielsweise braucht lediglich die Fotomaske modifiziert zu werden, mit der dann im Planarprozess auf einfache und besonders robuste Weise alle gleichartigen Bauteile indiziert werden können.

Durch die in den Unteransprüchen aufgeführten Maßnahmen sind vorteilhafte Weiterbildungen und Verbesserungen der im Anspruch 1 angegebenen Halbleiter-Chips möglich.

Besonders vorteilhaft erweist sich die Anordnung der Kennzeichnungen auf zwischen den Halbleiterstrukturen (Layouts) von jeweils benachbarten Halbleiter-Chips liegenden Randbereichen. Schaltungstechnische Eingriffe und Einflüsse können dadurch vermieden werden, wobei für die Kennzeichnungen auf den Randbereichen genügend Platz zur Verfügung steht. Ein weiterer Vorteil ist die gute Ablesbarkeit der Kennzeichnungen auf diesen Randbereichen. Auch bereits existierende Bauteile können mit derartigen Kennzeichnungen indiziert werden, ohne daß dabei die Layouts geändert werden müssen. Der Randbereich zwischen zwei Chips, der sogenannte Sägegraben, kann ohnehin bis zu einer gewissen Breite für Layout-Bestandteile nicht genutzt werden, da beim Auseinandersägen der Platte zum einen ein Streifen weggesägt wird und zum anderen Sägetoleranzen berücksichtigt werden müssen, wobei aus Gründen der Justiertoleranz die Lage der Sägespur innerhalb des Sägegrabens nicht exakt vorherbestimmt werden kann.

Zweckmäßigerweise werden die den benachbarten Halbleiter-Chips zugeordneten Kennzeichnungen auf den dazwischen liegenden, gegenüber den Kennzeichnungen breiteren Randbereichen zum jeweils zugeordneten Halbleiter-Chip hin versetzt angeordnet. Hierdurch ist unabhängig von der Justiertoleranz der Sägespur eine einwandfreie Zuordnung der verbleibenden Kennzeichnungen zum jeweiligen Chip möglich. Die Breite der Kennzeichnungen kann dabei so bemessen werden, daß bei optimalem, mittigem Schnitt jeder Chip nach der Vereinzelung auf seinen Randbereichen nur noch die eigenen Kennzeichnungen trägt.

Wenigstens der Randbereich an einer der vier Seiten der Halbleiterstruktur wird mit wenigstens einer der Kennzeichnungen versehen. Zur Erhöhung der Ablesesicherheit auch bei fehlerhaften Einflüssen können mehrere gleichartige Kennzeichnungen vorgesehen sein. Es können auch die Randbereiche von zwei gegenüberliegenden Seiten oder von allen Seiten mit derartigen Kennzeichnungen versehen werden.

Die Ausbildung der Kennzeichnungen als Folgen von Strich- oder Flächenelementen führt zu einer einfachen Realisierung und zu einer leichten Ablesbarkeit. Da diese Strich- oder Flächenelemente zweckmäßigerweise senkrecht zur Chip-Kante durch die Randbereiche verlaufen, werden sie beim Schneiden der Platte allenfalls verkürzt und verlieren daher nicht ihren Informationsinhalt.

Wegen der guten Ablesbarkeit und ihrem klaren, auch durch Fehleinflüsse kaum beeinflußbaren Informationsinhalt eignet sich vor allem eine Binärcodierung der Folgen von Strich- oder Flächenelementen.

Ein weiterer Beitrag zur klaren und einfachen Ablesbarkeit kann dadurch erfolgen, daß die Kennzeichnungen jedes Halbleiter-Chips zwei im wesentlichen gleichartige, die Zeilen- und die Spalten-Nummern der jeweiligen Chip-Position angebende Bereiche aufweisen.

Weiterhin kann noch eine Markierung zur besseren Unterscheidung der beiden Bereiche vorgesehen sein. Diese kann als Richtungszeiger ausgebildet sein und vorzugsweise zum anderen Bereich und/oder zur Plattenkante hinweisen. Im einfachsten Falle kann eines der Strich- oder Flächenelemente als Markierung zur Unterscheidung der beiden Bereiche ausgebildet sein. Durch eine derartige Anordnung kann zusätzlich die Drehlage eines vereinzelten Chips festgestellt werden und darüber hinaus ist keine Verwechslung der beiden Bereiche untereinander, also von Zeilen- und Spaltennummern möglich.

Die Kennzeichnungen können in vorteilhafter Weise noch weitere chipspezifische Daten enthalten, wie Variantenkennzeichnung, Prozessmodifikation, Daten und dergleichen.

Die Anbringung der Kennzeichnungen kann prinzipiell fast in jedem Prozess-Schritt bei der Herstellung der Chips erfolgen. Ganz besonders einfach und robust können diese Kennzeichnungen als Oxidelemente im Lithografieschritt dargestellt werden, in dem zum letzten Mal Oxidfenster geöffnet werden. Beim Bipolar-Planarprozess wäre dies beispielsweise die Kontaktfensterebene. Die Indizierung erfolgt dann während des Planarprozesses ohne jeglichen zusätzlichen Aufwand. Die Oxidstruktur der Kennzeichnungen stellt sicher, daß bei späteren technologischen Analysen, bei denen das Vorderseiten-Metall entfernt werden muß, die Kennzeichnungen auch danach noch vorhanden sind.

Zur Anbringung der Kennzeichnungen sind lediglich Änderungen bei der Muttermaske nötig. Alle Kopien davon erhalten die Kennzeichnungen ohne Zusatzaufwand automatisch beim Kopieren. Bestehende Layouts können ohne weiteres noch nachträglich durch Änderung der Maske mit derartigen Kennzeichnungen versehen werden.

### Zeichnung

Ausführungsbeispiele der Erfindung sind in der Zeichnung dargestellt und in der nachfolgenden Beschreibung näher erläutert. Es zeigen:
- Figur 1: den mit binärcodierten Strichelementen versehenen Randbereich zwischen zwei Chips in einer schematischen Darstellung,
- Figur 2: binärcodierte Flächenelemente im oberen Bereich des rechten Seitenrands eines Chips und
- Figur 3: diese Flächenelemente im unteren Bereich des linken Seitenrands desselben Chips.

### Beschreibung der Ausführungsbeispiele

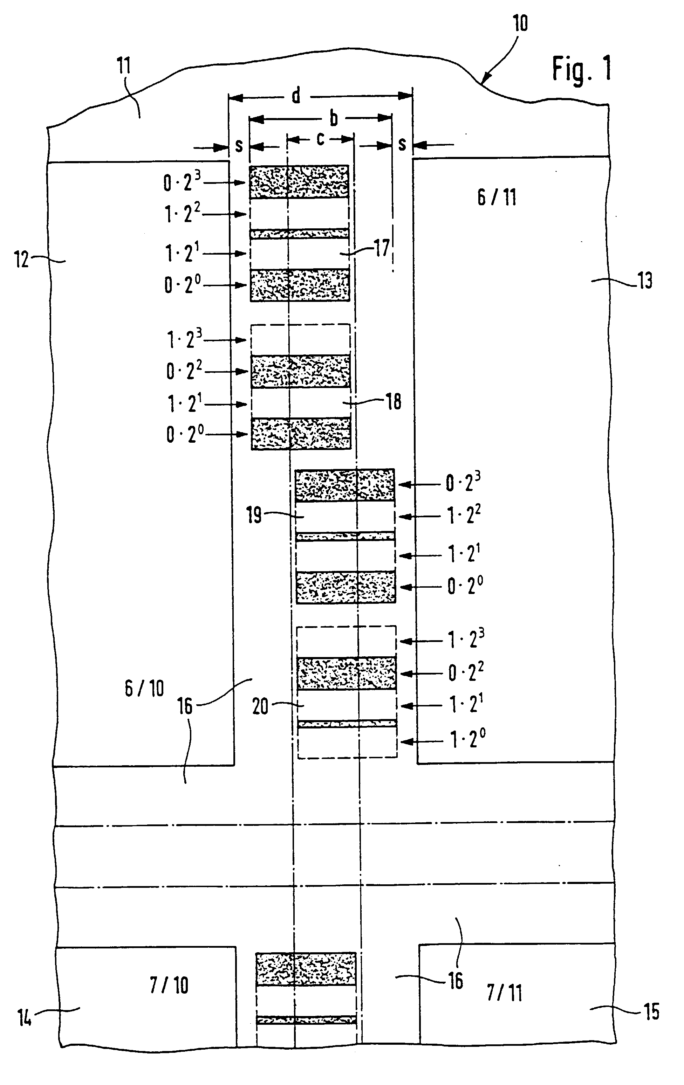

Die schematische Darstellung gemäß Figur 1 zeigt die Draufsicht auf einen Teilbereich 10 eines Wafers 11, auf dem eine Vielzahl von elektronische Bauteile oder elektronische Schaltkreise enthaltende, gleichartige Chips angeordnet sind. In Figur 1 sind vier solcher Chips 12 - 15 ausschnittsweise dargestellt. Diese Chips werden durch aus der Halbleitertechnologie bekannte Verfahren auf den Wafer 11 aufgebracht, beispielsweise durch den Bipolar-Planarprozess. Die Chips sind symmetrisch in Zeilen und Spalten angeordnet, wobei der Chip 12 in Zeile 6, Spalte 10, der Chip 13 in Zeile 6, Spalte 11, der Chip 14 in Zeile 7, Spalte 10 und der Chip 15 in Zeile 7, Spalte 11 angeordnet sein soll. Die innere Struktur der Chips ist zur Vereinfachung nicht dargestellt.

Zwischen den einzelnen Chips 12 - 15 befinden sich Randbereiche 16 der Breite d, die die sogenannten Sägegräben darstellen. Diese Randbereiche 16 können bis zu einer gewissen Breite für Layout-Bestandteile der Chips nicht genutzt werden, weil beim Auseinandersägen des Wafer 11 zur Vereinzelung der Chips Sägeschnitte der Breite c durch die Randbereiche 16 durchgeführt werden. Streifen der Randbereiche mit der Breite c fallen dadurch weg. Der Rest der Breite muß freigehalten werden, weil aus Gründen der Justiertoleranz die Lage der Sägespur innerhalb der Randbereiche 16 nicht exakt vorhergesagt werden kann und so der Sägeschnitt ganz links am Chip 12 oder auch ganz rechts am Chip 13 liegen kann.

Anstelle der Vereinzelung der Chips durch Auseinandersägen des Wafer 11 können die Randbereiche 16 auch geritzt und danach gebrochen werden. In jedem Falle entfällt jedoch ein Streifen Material vom Randbereich 16.

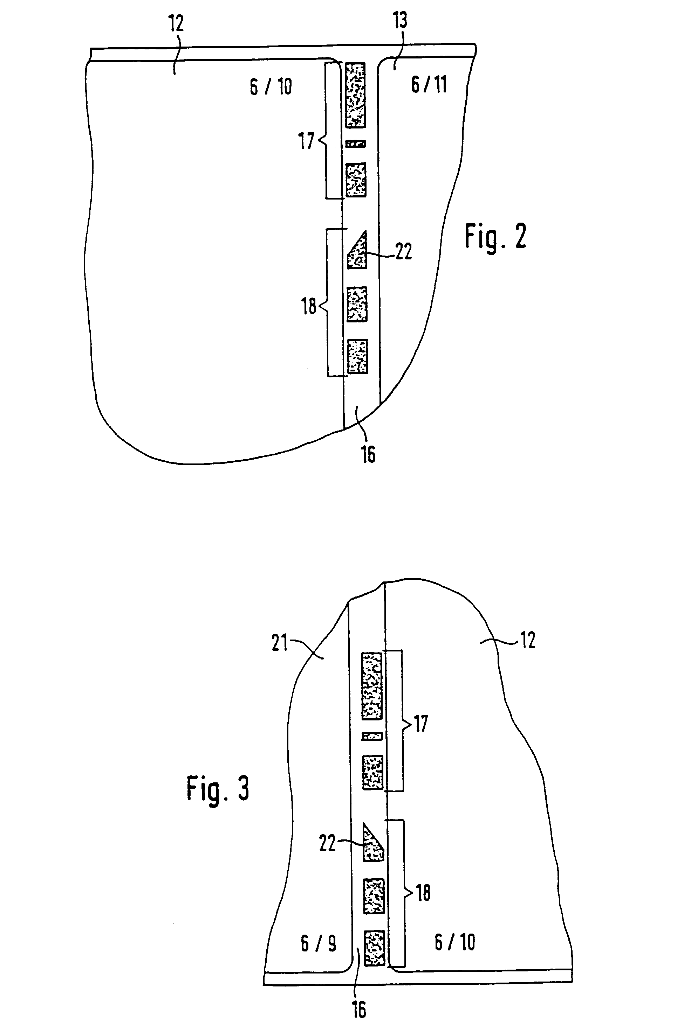

Im vertikalen Randbereich 16 zwischen den Chips 12 und 13 bzw. den Chips 14 und 15 sind aus benörcodierten Strichelementen bestehende Kennzeichnungen vorgesehen. Diese Strich-elemente verlaufen dabei senkrecht zur Kante der Halbleiterstrukturen (Layouts) der Chips, also quer durch die Randbereiche 16. Die beiden oberen, nach links versetzten Bereiche 17, 18 von Kennzeichnungen sind dem Chip 12 zugeordnet, während die unteren beiden, nach rechts versetzten Bereiche 19, 20 von Kennzeichnungen dem Chip 13 zugeordnet sind. Dabei bilden die Bereiche 17, 18 zum Chip 12 hin einen Sicherheitsabstand s, ebenso wie die Bereiche 19, 20 zum Chip 13 hin. Dieser Sicherheitsabstand s dient dazu, Einflüsse der Kennzeichnungen auf die Halbleiterstrukturen der Chips mit Sicherheit auszuschließen. Durch diese Sicherheitsabstände s verringert sich die für Kennzeichnungen nutzbare Breite der Randbereiche auf den Wert b. Zur Verdeutlichung der Funktionen und der Anordnung der Kennzeichnungen ist die Darstellung gemäß Figur 1 nicht maßstabsgetreu ausgeführt. Tatsächlich sind die Randbereiche und Kennzeichnungen im Vergleich zur Größe der Chips wesentlich kleiner. Die Figuren 2 und 3 geben eine ungefähre Vorstellung der tatsächlichen Größenverhältnisse. Als Zahlenbeispiel sollen die folgenden Werte dienen: d = 80µm, s = 10 µm, c = 30 µm.

Bei symmetrischem Schnitt verbleibt somit jeweils ein Streifen für die Kennzeichnungen mit der Breite 15 µm.

Die Bereiche 17 und 19 geben dabei jeweils für die Chips 12 und 13 die Zeilennummer, im vorliegenden Falle für die Zeile 6 und die Bereiche 18, 20 die Spaltennummern wieder, im vorliegenden Falle für die Spalten 10 bzw. 11. Die Strichelemente in den Bereichen 17 bis 20 bestehen aus 0xid, beispielsweise aus strukturiertem Emitteroxid. Die Strichelemente stellen dabei 0-bits dar, während die freien Stellen 1-bits verkörpern. Zwischen zwei freien Stellen, also zwischen zwei 1-bits ist zur Verdeutlichung ein schmaler Oxid-streifen angeordnet. Die digitale Codierung durch die Strich-elemente ist in Figur 1 durch entsprechende Zahlenangaben erläutert.

Rein technologisch gesehen, lassen sich die Kennzeichnungen in fast jedem Prozess-Schritt während der Herstellung der Chips auf den Wafer 11 aufbringen. Besonders einfach und robust können die Kennzeichnungen im Lithografieschritt dargestellt werden, in dem zum letzten Mal Oxidfenster geöffnet werden. Beim Bipolar-Planarprozess wäre dies die Kontaktfensterebene. Hierzu muß ausschließlich die Kontaktfenstermaske bei der Herstellung im Pattern-Generator und Repeater mit den Kennzeichnungs-Strukturen neben jedem Chip versehen werden. Alle anderen Masken oder Ebenen bleiben unverändert. Im Bereich der bits wird das Oxid im Sägegraben nicht abgeätzt, sondern es wird nur da entfernt, wo in der Binärdarstellung der Spalten- oder Zeilennummern des Chips ein bit gesetzt werden soll. Die Breite des zu öffnenden Oxidfensters und der Abstand zweier benachbarten Fenster zueinander muß anhand der auftretenden Ätztoleranzen gewählt werden.

In Abwandlung der dargestellten und erläuterten Anordnung der Kennzeichnungen, kann selbstverständlich auch eine inverse Anordnung gewählt werden, bei der die Oxidelemente die 1-bits darstellen. Auch die schmalen Abstandsstreifen zwischen zwei freigeätzten Stellen können prinzipiell entfallen, da sie lediglich der besseren Lesbarkeit dienen. Weiterhin ist es möglich, mehrere Anordnungen von Spalten-bzw. Zeilenbereichen auf einer Seite des Chips oder über mehrere Seiten verteilt anzuordnen. Beim dargestellten Ausführungsbeispiel sind die Kennzeichnungen jeweils am rechten Seitenrand oben und am linken Seitenrand unten angeordnet. Auch die oberen und unteren Ränder können mit Kennzeichnungen versehen werden.

Im günstigsten Falle erfolgt der Sägeschnitt symmetrisch, so daß ein mittlerer Streifen der Breite c entfällt. In diesem Falle bleiben auf den verbleibenden Seitenrandbereichen der vereinzelten Chips nur die jeweils zugeordneten Kennzeichnungen erhalten, was prinzipiell die günstigste Lösung darstellt. Verläuft der Sägeschnitt jedoch unsymmetrisch, was in der Praxis kaum verhindert werden kann, so können im ungünstigsten Falle auf dem schmäleren Streifen die Kennzeichnungen ganz entfallen (wenn dieser kleiner oder gleich dem Sicherheitsabstand s ist) und auf dem breiteren Streifen des benachbarten Chips sind zusätzlich noch Kennzeichnungen enthalten, die nicht diesem Chip zugeordnet sind. Eine Unterscheidung ist dennoch leicht zu treffen, da die zugeordneten Kennzeichnungen eine wesentlich größere Ausdehnung infolge der Versetzung aufweisen. Der Wegfall der Kennzeichnungen auf dem benachbarten Chip ist ebenfalls unschädlich, da diesem wiederum auf der gegenüberliegenden Seite ein breiterer Randbereich erhalten bleibt.

In Figur 2 ist der rechte obere Bereich des Chip 12 und in Figur 3 der linke untere Bereich dieses Chips in einer maßstabsgetreueren Darstellung gezeigt. Während in Figur 1 zur Vereinfachung der Darstellung nur eine 4-bit-Kennzeichnung für die Spalten- bzw. Zeilennummern vorgesehen war, ist in den Figuren 2 und 3 eine 5-bit-Kennzeichnung realisiert. Die Bereiche 17 und 18 der Kennzeichnungen sind am oberen rechten und am unteren linken Seitenrand identisch. Im Gegensatz zu Figur 1 sind sie hier als Flächenelemente dargestellt, die keine eigentliche Strichform mehr aufweisen. Am linken seitlichen Randbereich des Chip 12 ist der darauf folgende Chip 21 in der Spalte 9 angeordnet.

Das jeweils oberste Kennzeichnungselement 22 der die Spalte angebenden Bereiche 18 ist pfeilspitzenartig ausgebildet und weist vom zugeordneten Chip 12 weg und zum Randbereich des ungesägten Wafer hin. Damit kann zum einen eine sichere Unterscheidung von Zeilen- und Spaltennummern gewährleistet werden und darüber hinaus kann die frühere Drehlage auf dem Wafer beim vereinzelten Chip festgestellt werden.

Die Randbereiche 16 können darüber hinaus noch weitere chipspezifischen Daten enthalten, beispielsweise die Kennzeichnung verschiedener Varianten eines Chiptyps, Prozeßmodifikationen, Herstellungsdatum, Herstellungsort und dergleichen. Die Kennzeichnungen für diese Daten können auf den 4 Randbereichen verteilt angeordnet werden.

## Patentansprüche

1. Verfahren zur Herstellung von gleichartige, monolithisch integrierte Schaltkreise enthaltenden Halbleiter-Chips aus einer Platte aus einkristallinem Halbleitermaterial, bei dem zuerst die gleichartigen, monolithisch integrierten Schaltkreise auf der Platte gebildet und dabei mit ihre Position auf der Platte beinhaltenden Kennzeichnungen versehen werden und bei dem anschließend aus der Platte die einzelnen, jeweils einen der monolithisch integrierten Schaltkreise enthaltenden Halbleiter-Chips durch Zerteilen der Platte in Randbereichen (16), die zwischen den Schaltkreisen liegen, hergestellt werden, dadurch gekennzeichnet, daß die Kennzeichnungen (17-20) auf der Platte auf den Randbereichen (16) gebildet werden und daß nach dem Zerteilen die einzelnen Halbleiter-Chips (12, 13, 14, 15) mit einer Kennzeichnung (17 - 20) auf mindestens einem Randbereich (16) versehen sind.

2. Verfahren nach Anspruch 1, dadurch gekennzeichnet, daß die den benachbarten Halbleiter-Chips (12, 13 bzw. 14, 15) zugeordneten Kennzeichnungen (17-20) auf den dazwischen liegenden, gegenüber den Kennzeichnungen breiteren Randbereichen (16) zum jeweils zugeordneten Halbleiter-Chip hin versetzt angeordnet werden.

3. Verfahren nach Anspruch 1 oder 2, dadurch gekennzeichnet, daß wenigstens der Randbereich (16) an einer der vier Seiten jedes Halbleiterchips mit wenigstens einer der Kennzeichnungen (17-20) versehen wird.

4. Verfahren nach Anspruch 3, dadurch gekennzeichnet, daß die Randbereiche (16) von zwei gegenüberliegenden Seiten jedes Halbleiterchips mit den Kennzeichnungen (17-20) versehen werden.

5. Verfahren nach einem der vorhergehenden Ansprüche, dadurch gekennzeichnet, daß die Kennzeichnungen (17-20) als Folgen von Strich- oder Flächenelementen ausgebildet werden.

6. Verfahren nach Anspruch 5, dadurch gekennzeichnet, daß die Strich- oder Flächenelemente senkrecht zur Chipkante durch die Randbereiche (16) verlaufen.

7. Verfahren nach Anspruch 5 oder 6, dadurch gekennzeichnet, daß die Folgen von Strich- oder Flächenelementen binärcodiert werden.

8. Verfahren nach einem der vorhergehenden Ansprüche, dadurch gekennzeichnet, daß die Kennzeichnungen (17-20) jedes Halbleiter-Chips zwei im wesentlichen gleichartige, die Zeilen- und die Spalten-Nummern der jeweiligen Chip-Position auf der Platte (11) angebende Bereiche aufweisen.

9. Verfahren nach Anspruch 8. dadurch gekennzeichnet, daß eine Markierung (22) zur Unterscheidung der beiden Bereiche (17, 18 bzw. 19. 20) vorgesehen wird.

10. Verfahren nach Anspruch 9, dadurch gekennzeichnet, daß die Markierung (22) als Richtungszeiger ausgebildet wird.

11. Verfahren nach Anspruch 10, dadurch gekennzeichnet, daß die Markierung (22) zum anderen Bereich und/oder zur Plattenkante hin weist.

12. Verfahren nach einem der Ansprüche 9 bis 11, dadurch gekennzeichnet, daß eines der Strich- oder Flächenelemente als Markierung (22) zur Unterscheidung der beiden Bereiche ausgebildet wird.

13. Verfahren nach einem der vorhergehenden Ansprüche, dadurch gekennzeichnet, daß die Kennzeichnungen weitere chipspezifische Daten enthalten, wie variantenkennzeichnung, Prozessmodifikation, Datum und dergleichen.

14. Verfahren nach einem der vorhergehenden Ansprüche, dadurch gekennzeichnet, daß die Kennzeichnungen (17-20) als Oxidelemente ausgebildet werden.

15. Verfahren nach Anspruch 14, dadurch gekennzeichnet, daß im Lithografieschritt dargestellte Oxidelemente vorgesehen werden.

## Claims

1. Process for producing semiconductor chips, containing identical monolithic integrated circuits, from a wafer of monocrystalline semiconductor material, in which the identical monolithic integrated circuits are first formed on the wafer and at the same time provided with labels containing their position on the wafer, and in which the individual semiconductor chips, each containing one of the monolithic integrated circuits, are subsequently produced from the wafer by dividing the wafer in edge regions (16) which are located between the circuits, characterized in that the labels (17-20) are formed on the wafer on the edge regions (16), and in that, after the division, the individual semiconductor chips (12, 13, 14, 15) are provided with a label (17-20) on at least one edge region (16).

2. Process according to Claim 1, characterized in that the labels (17-20) assigned to the neighbouring semiconductor chips (12, 13; 14, 15, respectively) are arranged, shifted towards the respectively assigned semiconductor chip, on the edge regions (16) which are located in between and are wider than the labels.

3. Process according to Claim 1 or 2, characterized in that at least the edge region (16) on one of the four sides of each semiconductor chip is provided with at least one of the labels (17-20).

4. Process according to Claim 3, characterized in that the edge regions (16) of two opposite sides of each semiconductor chip are provided with the labels (17-20).

5. Process according to one of the preceding claims, characterized in that the labels (17-20) are designed as sequences of line or area elements.

6. Process according to Claim 5, characterized in that the line or area elements extend, perpendicularly to the chip flank, through the edge regions (16).

7. Process according to Claim 5 or 6, characterized in that the sequences of line or area elements are binary-coded.

8. Process according to one of the preceding claims, characterized in that the labels (17-20) of each semiconductor chip have two essentially identical regions specifying the row and column numbers of the respective chip position on the wafer (11).

9. Process according to Claim 8, characterized in that a marking (22) for differentiating the two regions (17, 18; 19, 20, respectively) is provided.

10. Process according to Claim 9, characterized in that the marking (22) is designed as a directional pointer.

11. Process according to Claim 10, characterized in that the marking (22) points towards the other region and/or towards the wafer flank.

12. Process according to one of Claims 9 to 11, characterized in that one of the line or area elements is designed as a marking (22) for differentiating the two regions.

13. Process according to one of the preceding claims, characterized in that the labels contain further chip-specific data such as variant identification, process modification, date and the like.

14. Process according to one of the preceding claims, characterized in that the labels (17-20) are designed as oxide elements.

15. Process according to Claim 14, characterized in that oxide elements represented in the lithography step are provided.

## Revendications

1. Procédé de fabrication de puces semi-conductrices comportant des circuits de commutation intégrés monolithiques de même type dans une plaque d'un matériau semi-conducteur monocristallin, selon lequel on forme sur la plaque les circuits intégrés monolithiques de même type et on les munit de repères correspondant à leur position sur la plaque puis à partir de la plaque on fabrique les différentes puces semi-conductrices comportant les circuits de commutation intégrés monolithiques en divisant la plaque dans les zones marginales (16) situées entre les circuits, caractérisé en ce qu'on forme les repères (17-20) dans les zones marginales de la plaque et après division on munit les différentes puces semi-conductrices (12, 13, 14, 15) d'un repère (17-20) dans au moins une zone marginales (16).

2. Procédé selon la revendication 1, caractérisé en ce que les repères (17-20) associés aux puces semi-conductrices voisines (12, 13 ; 14, 15) sont prévues sur les zones marginales (16) intermédiaires, plus larges par rapport aux repères, en les décalant par rapport à la puce semi-conductrice à laquelle ils sont associés.

3. Procédé selon la revendication 1 ou 2, caractérisé en ce qu'au moins la zone marginale 16 de l'un des quatre côtés de chaque puce semi-conductrice reçoit au moins un repère (17-20).

4. Procédé selon la revendication 3, caractérisé en ce que les zones marginales (16) sont munies des repères (17-20) sur deux côtés opposés de chaque puce semi-conductrice.

5. Procédé selon l'une des revendications précédentes, caractérisé en ce que les repères (17-20) sont des suites d'éléments de traits ou de surfaces.

6. Procédé selon la revendication 5, caractérisé en ce que les éléments de traits ou de surfaces passent perpendiculairement au bord de la puce à travers les zones marginales (16).

7. Procédé selon les revendications 5 ou 6, caractérisé en ce que les suites d'éléments de traits ou de surfaces sont en codage binaire.

8. Procédé selon l'une des revendications précédentes, caractérisé en ce que les repères (17-20) de chaque plaquette semi-conductrice, comportent deux zones essentiellement de même type, indiquant les lignes et les numéros de ligne et de colonne de la position de la puce respective sur la plaque (11).

9. Procédé selon la revendication 8, caractérisé en ce qu'il est prévu un repère (22) pour distinguer les deux zones (17, 18 ou 19, 20).

10. Procédé selon la revendication 9, caractérisé en ce que les repères (22) sont des indicateurs de direction.

11. Procédé selon la revendication 10, caractérisé en ce que les repères (22) sont décalés vers l'autre zone et/ou l'autre bord de plaque.

12. Procédé selon l'une des revendications 9 à 11, caractérisé en ce que l'un des éléments de trait ou de surface constitue un repère (22) pour distinguer les deux zones.

13. Procédé selon l'une des revendications précédentes, caractérisé en ce que les repères comportent d'autres données caractéristiques de chaque puce, telles que les caractéristiques relatives aux variantes, les modifications de procédé, les données ou analogues.

14. Procédé selon l'une des revendications précédentes, caractérisé en ce que les repères (17-20) sont des éléments d'oxyde.

15. Procédé selon la revendication 14, caractérisé en ce que les éléments d'oxyde sont réalisés par une photo-lithographie.
